# EUROPÄISCHE PATENTSCHRIFT

(11) **EP 0 527 980 B1**
(45) Veröffentlichungstag und Bekanntmachung des Hinweises auf die Patenterteilung: **11.06.1997**
(21) Anmeldenummer: 92904744.7
(22) Anmeldetag: 21.02.1992
(51) Int. Cl.: B07B 1/46, B01D 67/00, H05K 3/00, G02B 6/12

(54) **VERFAHREN ZUR HERSTELLUNG EINES AUS MIKROSIEBEN BESTEHENDEN VERBUNDKÖRPERS**
METHOD OF MANUFACTURE OF A COMPOSITE BODY CONSISTING OF MICROSIEVES
PROCEDE DE FABRICATION D'UN CORPS COMPOSITE CONSTITUE DE MICROTAMIS

(30) Priorität: 28.02.1991 CH 612/91; 18.02.1992 CH 477/92
(43) Veröffentlichungstag der Anmeldung: 24.02.1993
(73) Patentinhaber: DYCONEX PATENTE AG, 6300 Zug (CH)
(72) Erfinder: SCHMIDT, Walter, CH-8050 Zürich (CH); MARTINELLI, Marco, CH-8413 Neftenbach (CH); FREI, Alexandra, CH-8400 Winterthur (CH)
(74) Vertreter: Frei, Alexandra Sarah
(86) Internationale Anmeldenummer: CH9200035
(87) Internationale Veröffentlichungsnummer: WO9215408

(56) Entgegenhaltungen:
- EP-A- 0 168 509
- EP-A- 0 283 546
- DE-A- 3 816 078
- FR-A- 1 398 082
- FR-A- 2 117 172
- US-A- 3 265 546
- US-A- 3 812 972
- US-A- 4 788 766
- US-A- 4 889 585

## Beschreibung

Die Erfindung betrifft ein Verfahren zur Herstellung eines Verbundkörpers nach dem Oberbegriff des unabhängigen Patentanspruchs. Der Verbundkörper weist ein vorgegebenes, beliebig vernetztes und sich in x-, y-, und z-Richtung erstreckendes Mikro-System von hohlen Kanälen und/oder festen Leitern auf und wird durch Aufeinanderschichten von Mikrosieben hergestellt.

Es ist aus der Elektronik bekannt, Leiterplatten aus flexiblen oder steifen Folien oder Platten verschiedener Kuststoffe herzustellen, wobei es notwendig ist, möglichst kleine Löcher an exakt vorgegebenen Orten einzubringen. Durch diese Löcher können dann die zwei leitenden Metallschichten beiderseits der Folien miteinander leitend verbunden werden, indem die Löcher mit einem leitenden Material gefüllt, beispielsweise durchplattiert werden.

In der Publikation FR-2117172 ist eine derartige Multilayer-Leiterplatte beschrieben. Diese besteht aus einer Mehrzahl von dünnen Platten aus Epoxyharz, welche Platten beidseitig (oder einseitig) Leitermuster aufweisen, wobei die Leitermuster der beiden Seiten durch durchplattierte Löcher durch die Platte hindurch leitend miteinander verbunden sind. Die derart strukturierten Platten werden zu einem Multilayer aufeinandergeschichtet, wobei immer zwischen zwei Platten eine isolierende, nicht strukturierte Verbindungsschicht eingebracht wird. Zur elektrischen Verbindung der Leitermuster der einzelnen Platten miteinander werden durch den Multilayer - das heisst durch den ganzen Stapel von miteinander verbundenen Platten - Löcher gebohrt und metallisiert.

Die Leiterplatte gemäss FR-2117172 stellt einen Verbundkörper dar, der aus einzelnen sich im wesentlichen in x- und y-Richtung erstreckenden, strukturierten Schichten besteht. Das Leitersystem des Verbundkörpers besteht aus sich ebenfalls im wesentlichen in x- und y-Richtung erstreckenden Untersystemen, die in z-Richtung miteinander verbindbar sind durch Löcher, die sich quer zur Schichtung des Verbundkörpers geradlinig durch den Verbundkörper erstrecken.

Es wäre nun wünschenswert, über ein Material zu verfügen, das nicht nur zum Leiten von elektrischen Strömen, sondern auch für den Durchtritt von fluidischen Materialien oder materiefreier Erscheinungsformen wie Licht (Photonen) oder elektromagnetische Strahlung geeignet ist, wobei dieser Durchtritt im Mikromassstab und in exakt bestimmter, also determinierter Form zu erfolgen hat. Ein derartiges Material weist ein System von Festkörperbahnen oder hohlen Kanälen oder eine Mischung aus beidem auf. Ein derartiges Material würde Kontroll- und Steuermöglichkeiten im Mikrobereich eröffnen, die im Folgenden noch angesprochen werden sollen.

Es ist also die Aufgabe der Erfindung, ein Verfahren aufzuzeigen, mit dem ein Verbundkörper mit einem geschichteten Aufbau herstellbar ist, welcher Verbundkörper ein vorgegebenes Mikro-System von in x-, y- und z-Richtung beliebig vernetzten, festen Leitern und/oder hohlen Kanälen aufweist.

Diese Aufgabe wird gelöst durch das Verfahren, wie es in den Patentansprüchen definiert ist.

Das erfindungsgemässe Verfahren besteht im wesentlichen darin, aus ein- oder beidseitig beschichteten Kunststoffolien Mikrosiebe mit vorgegebenen Strukturen in Form von hohlen oder mit einem Festkörper gefüllten Durchgängen und Beschichtungsstrukturen herzustellen und diese Mikrosiebe aufeinander zu stapeln und miteinander zu verbinden. Dabei werden die Strukturen jedes Mikrosiebes auf die vorgegebene Struktur des herzustellenden Verbundkörpers und auf Strukturen von im Verbundkörper benachbarten Mikrosieben abgestimmt und die Mikrosiebe werden derart aufeinander gestapelt, dass ihre Strukturen zusammen das vorgegebene Mikro-System von in x-, y- und z-Richtung beliebig vernetzten Leitern und/oder Kanälen bilden.

Die Leiter und/oder Kanäle des Verbundkörpers sind, wie bereits erwähnt, tubulare Bahnen (Kanäle), also hohlräumlich, oder Festkörperbahnen oder eine Mischung von beiden. Sie sind also im weitesten Sinne leitend, das heisst sie können materiefreie Erscheinungsformen wie Licht, elektromagnetische Strahlung oder elektrische Ströme oder aber fluide Materialien leiten.

Die Leiter und/oder Kanäle des Verbundkörpers bilden, wie bereits erwähnt, ein Mikrosystem. Dies bedeutet, dass die Strukturen der Mikrosiebe eines Verbundkörpers sehr exakt vorgegeben (determiniert) sind und sehr exakt hergestellt werden müssen.

Je kleiner eine Durchtrittsstelle durch ein Material sein soll und je präziser sie bezüglich des Oeffnungsquerschnittes sein soll, desto kürzer muss der Durchtrittsweg sein, das heisst, dass die determinierte Anordnung (das kann ein gleichmässiges Muster sein, es kann aber auch ein ungleichmässig, aber determiniertes Muster sein) in ein möglichst dünnes flächiges Gebilde eingebracht wird, bspw. in eine Folie. Mit Folien lassen sich auf bestimmte Weise solche "Ordnungssiebe" herstellen. Längere Durchtrittswege erreicht man durch nachträgliches Verbinden von Mikrosieben zu einem Diaphragma.

Dies setzt voraus, um die nötige Exaktheit zu erhalten, dass erstens solche eine Folie bezüglich eines Verziehens bei Herstellung und Gebrauch stabilisiert werden muss, zweitens das Einbringen der Durchlässe kräftefrei zu erfolgen hat und drittens unabhängig vom Feinheitsgrad (Durchlässe pro Flächeneinheit) stets die gewünschte Determiniertheit erhalten bleibt (Präzisionsinvarianz).

Dies wird folgendermassen erreicht:

Folien mit einer Dicke in der Grössenordnung von 30-50µ werden auf einer oder auf beiden Seiten mit einer geeigneten Schicht, in diesem Falle eine Metallschicht, in einer Dicke der Grössenordnung von 7-10µ laminiert. Eine Metallschicht wirkt auf geringe Zugbelastungen stabilisierend und führt innerhalb der Elastizitätsgrenze Verformungen wieder zurück in den ursprünglichen Zustand. Man muss sich natürlich im klaren sein, dass man es hier mit sehr feinen Gebilden zu tun hat (Mikrotechnik), bei denen ein ganz anderer Masstab für Bearbeitungsbelastung anzulegen ist, als in makroskopischen Arbeitstechniken Ferner wird die Präzision der Abbildungstechnik durch möglichst dünne Folien unterstützt, da sich solche Folien an den (meist) dickeren Film mit dem zu übertragenden Muster, also die gewünschten Mikrostrukturen, gut anschmiegen, es entsteht also kein Offset. Verwendet man als Metallbelag Kupfer, so kann dieser Belag gleich als Aetzresist dienen Dünne Kunststoff-Folien mit Metallbeschichtung sind im Handel erhältlich. Es kann jedoch nötig sein, Folien mit einer Spezialbeschichtung selber herzustellen. In der Regel wird man jedoch ein geeignetes Handelsprodukt aus dem Angebot auswählen können.

Wie oben schon ausgeführt, kommen "serielle" Verfahren aus verschiedenen Gründen nicht in Frage. Bei den simultan wirkenden Verfahren kommt bei der geforderten Präzision ein Nassätzverfahren wegen der relativ starken Unterätzung, was bei einer Makrotechnik wenig ins Gewicht fällt, nicht in Frage. Es wird deshalb ein Plasmaätzverfahren vorgeschlagen, das alle Voraussetzungen erfüllt. Derart dünne Folien könnten auch mittels Lasertechnik durchrastert werden, aber bei der geforderten Vielzahl von Durchgängen kommt diese Technik, die eine sehr schnelle serielle Technik, man denke an das Laserschneiden, kaum mehr in Frage. Man muss sich ausschliesslich auf Simultantechniken beschränken, die in diesem Falle die adäquatesten sind.

Völlig im Gebiet der Mikrotechnik liegt dann die Herstellung von determinierten Mehrlagensieben (Verbundkorper), die schliesslich zu den determinierten Verbundkörpern führen. Stellt man sich vor, dass in einem Paket von mehreren solcher Folien Metallagen (anorganisches Material) und Kunststofflagen (organisches Material) abwechselnd vorhanden sind, so können gegenseitig versetzte Raster mit Durchgängen in z-Richtung durch Kondukte (Kanäle, Leiter oder dergleichen) in x,y-Richtung verbunden werden (hier zeigt sich die Relevanz der geforderten Determiniertheit des Rasters). Je nachdem, wie die durchgeführten Fluide oder materielosen Effekte auf das Material der Kaschierung sich auswirken, können bspw. im Falle von Fluiden die fertiggeprägten Einzellagen noch mit Gold bedampft werden.

Ein solches Tubularsystem (Hohlkondukte) kann nun bspw. mit bestimmten biologisch wirksamen Stoffen, bspw. mit kleinen Peptiden wie Penta- bis Dodekapeptiden konditioniert werden (Oberflächenwirkung), um dann ein Fluid durchzuschleusen, das bspw. von ganz bestimmten Molekülen oder Ionen gereinigt werden soll, oder dem ganz bestimmte Moleküle oder Ionen zugegeben werden soll. In einem Folgezyklus findet die Auswaschung, dann wieder die Konditionierung und dann wieder die Reinigung statt. Warum nun gerade ein determiniertes Tubularsystem? Weil ein solches für Zu- und Weg-Führungen von Fluiden gruppiert werden kann, was erlaubt, ein Netz von Mikrogefässen herzustellen, wie das in der Natur ebenfalls vorkommt und welches Mikronetz für Zyklen, wie sie oben diskutiert wurden, gezielt geschaltet werden können. Auf diese Weise bekommt man Fluidführungen im Mikrogebiet in den Griff, die früher nur makroskopisch durchführbar waren (Schlauchtechnik). Man weiss heute, dass Gebilde in der Natur, die früher für ungeordnet gehalten wurden, hochdeterminierte Gebilde sind. Unser Umgang mit Körperfunktionen, bspw. durch künstliche Nieren, sie sind alles andere als eigentliche Nieren, es sind eher makroskopische Waschsysteme ohne Aehnlichkeit mit der tatsächlichen Funktion einer Niere, genau genommen ist sie nicht mal funktionell ähnlich. Es gibt aber noch eine ganze Anzahl weiterer Funktionen im Mikrogebiet, die mittels der Technik gemäss Erfindung nachgebildet werden können.

Solch ein Tubularsystem kann aber auch in der analytischen Chemie als alternierender und/oder rezyklischer Indikator verwendet werden (Laden, Separieren, Eluieren, Messen, Laden ...), es kann in der physikalischen und chemischen Forschung zur Isolierung seltener Stoffe verwendet werden und es findet noch ein weiteres überraschendes Applikationsfeld, nämlich hochkomplexe, mikrofeine Leiterplatten. Wie dies?

Betrachtet man ein solches Tubularsystem, dann besteht es aus Kanälen, die zu Durchleitungen in Wänden zu weiteren Kanälen führen. Tuben sind Hohlräume zur Leitung von Fluiden. Betrachten wird jedoch das Negativ davon, dann hat man statt Kanäle Festkörperbahnen, die ebenso gut durch Trennwände leiten können, um sich mit weiteren Festkörperbahnen zu verbinden. Bestehen solche Festkörperbahnen aus Metall, so können sie Strom leiten und werden zu Leiterbahnen, bestehen sie aus einem für Licht transparenten Material, können sie Licht leiten und werden zu Lichtleitern. Aus einem determinierten Tubularsystem ist ein determiniertes Leitersystem geworden. Damit eignet sich das Verfahren gemäss Erfindung auch zur Herstellung komplexer Leiterplatten in Mikroausführung (hohe Leiterdichte, sehr dünne Multilayer). Auch eine hybride Lichtleittechnik könnte mit dieser Methode realisiert werden.

Man sieht, dass die Technik für determinierte Mikrosiebe und determinierte Diaphragmen (komplexere Konduktsysteme) ein ausnehmend grosses Applikationsfeld aufweist, das im Moment nicht absehbar ist. Jedoch kann man heute schon eine ausreichende Lehre für die Positiv/Negativ-Technik, also Tubular (Hohlraum) und Leiter (Festkörper) angeben, um damit beide Systeme herzustellen.

Für die Lochung von Kunststoffolien, die aus funktionellen Gründen ohnehin beidseitig mit einer Metallschicht versehen sein müssen - wie z.B. in der Leiterplatten-Technik der Elektronikindustrie - kann man ein Verfahren der chemischen Locherzeugung anwenden. Dabei werden die beidseitig auf die Kunststoffolie aufgebrachten Metallschichten als Aetzresist verwendet. Als Aetzresist bezeichnet man einen Stoff, der dem Aetzmedium gegenüber resistent ist oder mindestens wesentlich resistenter als das zu aetzende Material.

Wird ein Aetzverfahren verwendet, so kann dies ein nasschemisches Verfahren sein, bei dem das Aetzmedium in flüssiger Form vorliegt. Aus oben angegebenen Gründen wird von dieser Methode Abstand genommen, da mit dieser Methode nicht die gleiche Präzision erreichbar ist wie mit anderen Aetzverfahren, in denen das Aetzmedium gasförmiger Art ist, was z.B. beim Plasmaaetzen der Fall ist. Ebenso sind allenfalls Kombinationen der genannten Verfahren möglich. Bei allen Aetzverfahren muss im allgemeinen jedoch dafür gesorgt werden, dass diejenigen Teile, die nicht weggeätzt werden sollen, durch eine Aetzresistschicht geschützt sind. Aetzverfahren haben den Vorteil, dass eine Vielzahl von Oeffnungen gleichzeitig aus einer Folie herausgeätzt werden können.

Die Genauigkeit dieses Verfahrens ist durch die Genauigkeit der erfolgten Strukturierung der Aetzresistschicht und der Dicke der zu ätzenden Kunststoffolie bestimmt. Wird z.B., wie in der Elektronikindustrie bekannt, eine photochemische Strukturierung und ein Photolack als Aetzresist für die Fensteröffnungen in der Metallschicht verwendet, so können Durchgangslöcher mit Durchmessern von 10-100 µm einfach hergestellt werden. Aetzverfahren haben also auch den Vorteil, dass die Löcher sehr viel kleiner sein können als mit mechanischen Mitteln herstellbar. Natürlich ist es auch möglich, Durchgangslöcher mit grösseren Durchmessern oder beliebigen Konturen zu erhalten. Für grosse Löcher braucht nicht alles Material herausgeätzt zu werden, es genügt in solchen Fällen, den Lochrändern entlang durchzutrennen, wonach die losen Teile herausfallen.

Die Plasmaätzung hat den Vorteil, dass auch anisotrop, d.h. gerichtet geätzt werden kann, wodurch eine Unterätzung weitgehend vermieden wird. Eine Unterätzung ist eine meist unerwünschte Ausätzung unter dem Aetzresist, bei Löchern also in seitlicher Richtung bezüglich der Lochachse. Plasmaätzanlagen können so konstruiert sein, dass in einem kontinuierlich ablaufenden Verfahren die Kunststoffolie von Rolle zu Rolle verarbeitet wird.

Werden Sieböffnungen in einer Kunststoffolie ohne eine Metallschicht gefordert, so kann man die Kunststoffolie durch Aufdampfen einer Metallschicht vorübergehend metallisieren und die Metallschicht nach erfolgter Lochung der Kunststoffolie wieder wegätzen.

Eine andere Verfahrensvariante sieht vor, bei geeigneter Kombination von Folienmaterial und Photoresist für die Strukturierung, den Photoresist selbst als Aetzresist für die Erzeugung der Löcher zu verwenden, wodurch sich ein Verfahrensschritt einsparen lässt. Wird der Photoresist ebenfalls durch das Aetzmedium angegriffen, so muss der Abtrag vom Photoresist langsamer erfolgen, als der Abtrag des Folienmaterials, so dass nach erfolgter Lochung immer noch ein Rest des Photoresists bzw. Aetzresists auf der Oberfläche verbleibt. Auch hier kann nötigenfalls der verbleibende Rest des Photoresists gestrippt, das heisst mit geeigneten, bekannten Verfahren entfernt werden.

Im folgenden wird die Erfindung anhand von zwei möglichen Ausführungsformen mit Zeichnungen näher erläutert. Es zeigen
- Figur 1 und Figur 2: ein Verfahren zur Lochung einer beidseitig mit Metallschichten versehenen Kunststoffolie,
- Figur 3: ein Verfahren zur Lochung einer unbeschichteten Kunststoffolie mittels Photolack,
- Figur 4: ein Verfahren zur Herstellung von Löchern in Kunststoffolien auf Bandanlagen,
- Figur 5: die Bildung eines Diaphragmas mit tubularen Kondukten (Kanälen),
- Figur 6: die Bildung eines Diaphragmas mit festen Kondukten (Leitern)

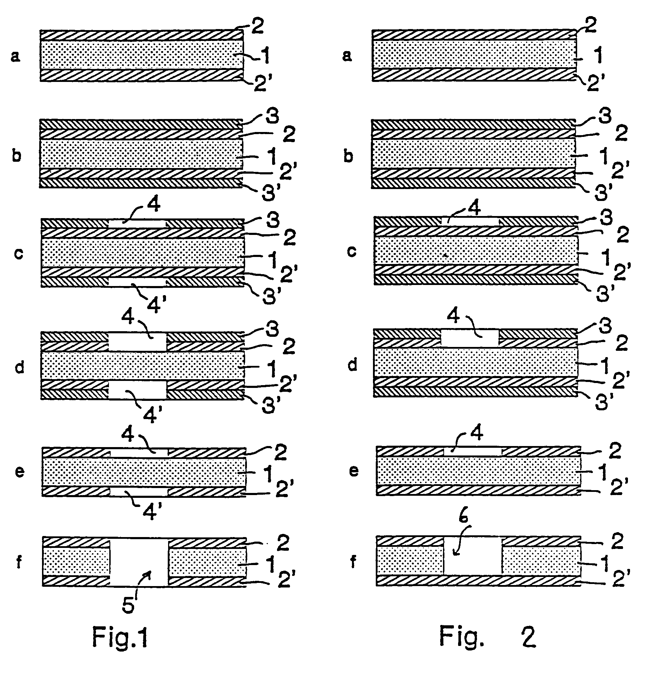

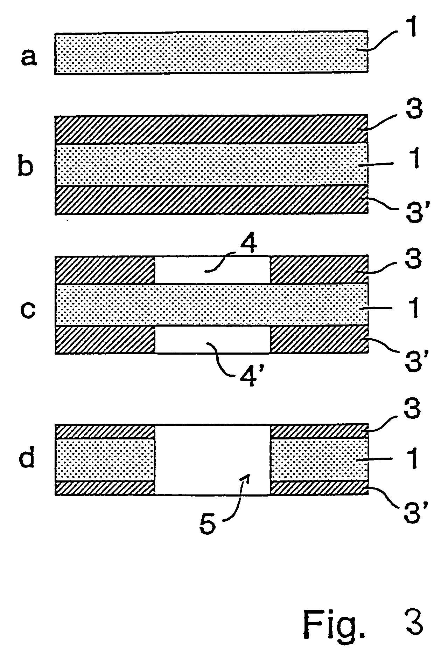

Figur 1a bis 1f und Figur 2a bis 2f zeigen die verschiedenen Stufen eines Verfahrens zur Lochung einer beidseitig mit Metallschichten versehenen Kunststoffolie. Da die Lochung mit den gleichen Verfahrensschritten erfolgt, werden die einzelnen Schritte im wesentlichen nur anhand von Figur 1a bis 1f erklärt.

Figur 1a zeigt in nicht masstabsgetreuer Darstellung eine beschichtete Kunststoffolie 1, beispielsweise aus Polyimid von 25 µm Dicke. Die Kunststoffolie 1 ist beidseitig mit einer Schicht 2, 2' aus Metall, beispielsweise Kupfer von 12 µm Dicke, bedeckt. Solche Schichten aus Metall können mit einem bekannten elektrolytischen Verfahren, durch Auflaminieren oder mit einer Sputter-Technik aufgebracht werden.

Figur 1b zeigt die Kunststoffolie 1 nach dem Aufbringen je einer Schicht 3, 3' aus Photoresist oder Photolack auf der Metallschicht 2, 2'. Das Aufbringen dieser Schicht 3, 3' kann auf an sich bekannte Weise z.B. mit einem Rollercoater und einem Durchlaufofen erfolgen.

Figur 1c zeigt die Kunststoffolie 1 nach einer Belichtung und Entwicklung der Schichten 3, 3' aus Photoresist mit dem gewünschten Lochbildmuster. In einem solchen Prozess wird das Lochbildmuster über beidseitig der Kunststoffolie 1 angebrachte, nicht gezeigte Photovorlagen in Form von Filmen oder von geätzten Metallmasken auf die Schichten 3, 3' aus Photoresist belichtet und diese anschliessend entwickelt. Letztere weisen dann Ausnehmungen 4, 4' an jenen Stellen auf, an denen Löcher entstehen sollen. In einer häufigen Anwendung soll die Kunststoffolie 1 mit Durchgangslöchern 5 versehen werden. Hierzu werden, wie gezeigt, zu den Ausnehmungen 4 in der Schicht 3 aus Photoresist an gegenüberliegenden Stellen der beidseitigen Beschichtung der Kunststoffolie 1 gleichgeformte Ausnehmungen 4' in der Schicht 3' angebracht. Das Oeffnen der Ausnehmungen 4' kann gleichzeitig mit dem Oeffnen der Ausnehmungen 4 erfolgen.

Andere Anwendungen sehen Löcher 6 in der Kunststoffolie vor, d.h. die in einem späteren Verfahrensschritt zu erzeugenden Löcher 6 sollen nur bis zur gegenüberliegenden Schicht 2' aus Metall reichen. In diesen Fällen wird an der betreffenden Stelle in der Schicht 3' keine Ausnehmung 4' angebracht, wie aus Figur 2c ersichtlich ist.

Figur 1d zeigt die Kunststoffolie 1 nach einer erfolgten Metallätzung. In einem solchen Prozess wird die Schicht 2, 2' aus Metall auf der Kunststoffolie 1 mit herkömmlichen Metallätzmitteln, so wie sie in der Leiterplatten-Technik verwendet werden, geätzt. Danach weisen auch die Schichten 2, 2' aus Metall Ausnehmungen 4, 4' an jenen Stellen auf, an denen Durchgangslöcher 5 oder Löcher 6 entstehen sollen. Der Zweck der Verfahrensschritte gem. Figur 1a bis 1d und gemäss Figur 2a bis 2d ist es also, die beidseitig beschichtete Kunststoffolie 1 an genau den Stellen von der Schicht 2,2',3,3' freizulegen, an denen Durchgangslöcher 5 oder Löcher 6 entstehen sollen. Grundsätzlich kann das Aetzen der Durchgangslöcher 5 oder der Löcher 6 bereits nach diesem Schritt einsetzen.

Figur 1e zeigt die Kunststoffolie 1 nach der erfolgten Befreiung von den nicht mehr benötigten Schichten 3, 3' aus Photoresist bzw. Photolack. Auch dieser Vorgang kann auf an sich bekannte Weise, z.B. mit einem in der Elektronikindustrie üblichen Photolackstripper, erfolgen. Die Kunststoffolie 1 weist jetzt beidseitig eine strukturierte Metallschicht auf, die dem Lochbildmuster entspricht und die als Aetzresist für den anschliessenden Lochätzprozess dient.

Figur 1f zeigt die Kunststoffolie 1 nach der erfolgten Aetzung der Durchgangslöcher 5 mit einem nasschemischen oder mit einem Plasmaätzverfahren. Auf diese Weise entstehen gratfreie Durchgangslöcher 5, oder wie in Figur 2f gezeigt, gratfreie Löcher 6. Wird ein anisotropes, also ein gerichtetes, Plasmaätzverfahren angewendet, so erfolgt die Aetzung praktisch ohne jegliche Unterätzung, d.h. es erfolgt kein unerwünschter seitlicher Abtrag der Kunststoffolie unterhalb des Aetzresists. Zusätzlich ist es auch möglich, dem Plasmaätzvorgang für die Erzeugung der Durchgangslöcher 5 oder der Löcher 6 eine nicht gezeigte Behandlung in einer Lösung vorzuschalten, die dann im Plasmaätzvorgang die Aetzzeit reduziert.

Aus dem beschriebenen Ablauf ist natürlich auch ersichtlich, dass Durchgangslöcher 5 und Löcher 6 - wobei letztere von der einen wie auch von der anderen Seite her eingebracht werden können - ohne weiteres im gleichen Arbeitsgang und auf der gleichen metallbeschichteten Kunststoffolie erstellt werden können.

Eine kupferbeschichtete Kunststoffolie 1, beispielsweise aus Polyimid, kann nach der erfolgten Lochung in einer Bandgalvanik nach den bekannten Verfahren der Leiterplattentechnik verkupfert werden, und dadurch erfolgt gleichzeitig eine Durchkontaktierung der Metallschichten.

Figur 3a bis 3d zeigt die verschiedenen Stufen eines Verfahrens zur Lochung einer beidseitig mit Photolack versehenen Kunststoffolie. Figur 3a zeigt in nicht masstabsgetreuer Darstellung eine Kunstoffolie 1, beispielsweise aus Polyimid.

Figur 3b zeigt die Kunststoffolie 1 nach der erfolgten beidseitigen Bedeckung mit je einer Schicht 3, 3' aus Photoresist bzw. Photolack. Solche Beschichtungen aus Photoresist können mit einer der in der Leiterplattenfabrikation bekannten Techniken aufgebracht werden.

Figur 3c zeigt die Kunststoffolie 1 nach einer Belichtung und Entwicklung der Schichten 3, 3' mit dem gewünschten Lochmuster. Die Schichten 3, 3' weisen jetzt Ausnehmungen 4, 4' an jenen Stellen auf, an denen Löcher entstehen sollen. Für das Herstellen von Durchgangslöchern 5 werden in der Schicht 3, 3' an gegenüberliegenden Stellen der beidseitigen Beschichtung der Kunststoffolie 1 gleichgeformte Ausnehmungen 4, 4' geschaffen. Auch dieser Vorgang erfolgt auf an sich bekannte Weise z.B. durch UV-Belichtung und anschliessende Entwicklung. Die Kunststoffolie 1 weist jetzt beidseitig eine strukturierte Photoresistschicht auf, die dem Lochbildmuster entspricht und die als Aetzresist für den anschliessenden Lochätzprozess dient.

Figur 3d zeigt die Kunststoffolie 1 nach der erfolgten Aetzung der Durchgangslöcher 5 mit einem nasschemischen oder mit einem Plasmaätzverfahren Auf diese Weise entstehen gratfreie Durchgangslöcher 5. Wird ein anisotropes, also ein gerichtetes, Plasmaätzverfahren angewendet, so erfolgt die Aetzung auch ohne Unterätzung, d.h. es erfolgt kein unerwünschtes seitliches Ausbreiten der Aetzung. Da in diesem Beispiel der Aetzresist aus einem Material besteht das lediglich ätzresistenter ist als die Kunststoffolie 1, wird auch am Aetzresist Material abgetragen. Die verbleibende Schicht aus Aetzresist nach der erfolgten Herstellung der Durchgangslöcher 5 ist somit dünner als zu Beginn. Soll die Schichtdicke der Kunststoffolie 1 nicht angegriffen bzw. verringert werden, so müssen Schichtdicke und Aetzresistenz des Aetzresists entsprechend gewählt werden. Stört der verbleibende Aetzresist bei der weiteren Verwendung der gelochten Folie, so wird dieser in einem weiteren Verfahrensschritt nach herkömmliche Techniken gestrippt, d.h. entfernt. Es ist sogar möglich, dass die Aetzung der Durchgangslöcher 5 und die abschliessende Entfernung des Photolacks bzw. des Aetzresists in einem einzigen Arbeitsgang erfolgen.

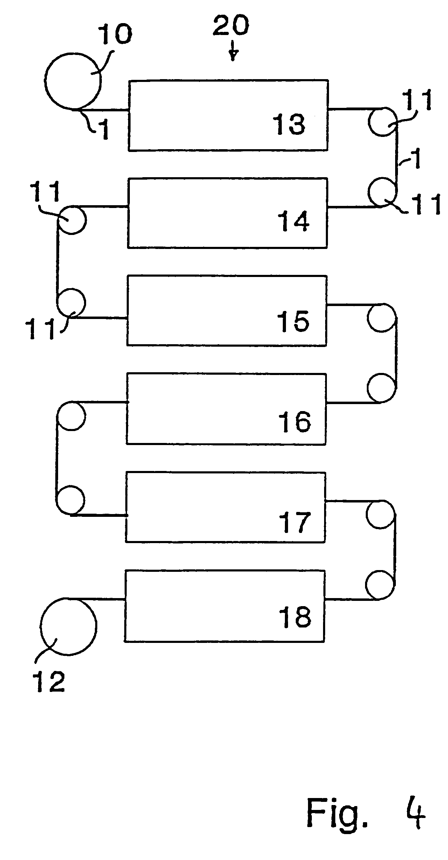

Figur 4 zeigt schliesslich ein Verfahren zur Herstellung von Löchern in Kunststoffolien auf Bandanlagen. Der Vorteil von kontinuierlich ablaufenden Verfahren besteht darin, dass Folien von Rolle zu Rolle verarbeitet werden können. Das Aetzen von Löchern in beidseitig beschichtete Kunststoffolien, so wie es z.B. in den Figuren 1a-1f und 2a-2f dargestellt und beschrieben ist, kann mit einer Bandanlage dieser Art erfolgen.

Von einer Vorratsrolle 10 wird die Kunststoffolie 1, die beidseitig mit einer Schicht 2, 2' aus Metall versehen ist, über verschiedene Verfahrensschritte und Transportrollen 11 letzlich einer Aufnahmerolle 12 zugeführt, die das fertige Produkt, nämlich die gelochte Folie, aufnimmt. In einem ersten Verfahrensschritt wird in einem Rollercoater 13 die Kunststoffolie 1 beidseitig mit einer Schicht 3, 3' aus Photoresist versehen. In einem Durchlaufofen 14 wird anschliessend die Schicht 3, 3' getrocknet. Dann erfolgt die notwendige Strukturierung des Lochmusters durch Belichtung in einem UV-Belichter 15 mit anschliessender Entwicklung in einer Entwicklungsanlage 16. Daraufhin wird in einem Metallätzer- und Photolackstripper 17 zuerst die Schicht 2, 2' aus Metall an den Ausnehmungen 4, 4' wo die Durchgangslöcher 5 oder die Löcher 6 entstehen sollen, weggeätzt und dann der übriggebliebene Photoresist entfernt. Schliesslich werden in einem Plasmareaktor 18 die Durchgangslöcher 5 und/oder die Löcher 6 herausgeätzt.

Wird eine Bandanlage von der Art verwendet wie sie in Figur 4 gezeigt ist, so ist es auch möglich, dass unter Hinzufügung von weiteren (nicht gezeigten) Verfahrensschritten im Durchlaufprozess auch die beidseitige Beschichtung der Kunststoffolie 1 mit Schichten 2, 2' aus Metall erfolgt. Dies kann mit einer bekannten Technik wie z.B. Auflaminierung oder Sputterung erfolgen.

Die Erfindung, so wie sie anhand von Figur 1-3 beschrieben wurde, eignet sich nicht nur zur Herstellung von Durchgangslöchern. Es ist auch möglich, dass die beidseitig beschichtete Kunststoffolie nur auf einer Seite mittels eines bekannten, z.B. photochemischen Prozesses strukturiert wird und dass nur auf dieser einen Seite die Aetzung ansetzt. Auf diese Weise ist es auch möglich, Löcher 6 oder andere Vertiefungen zu schaffen.

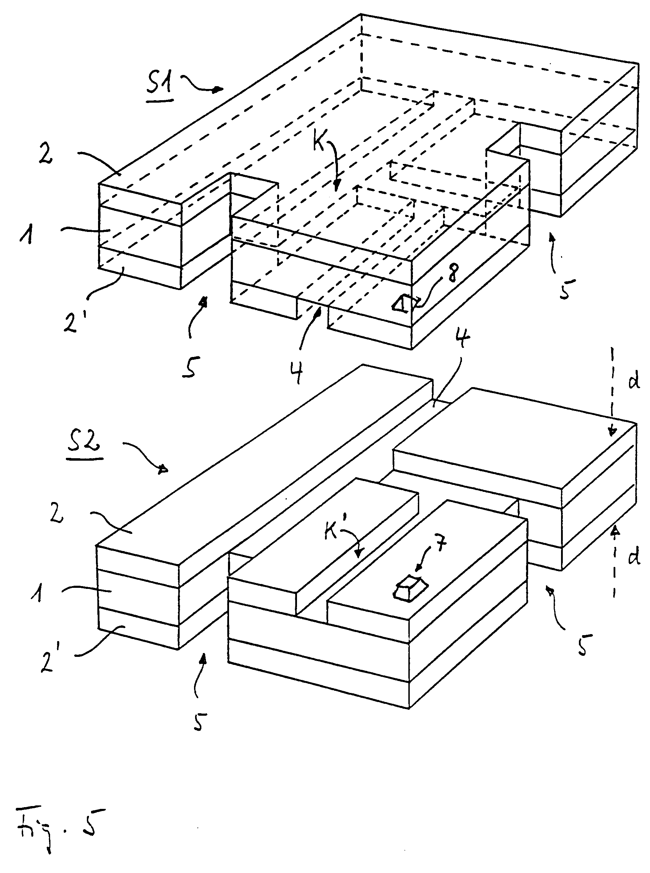

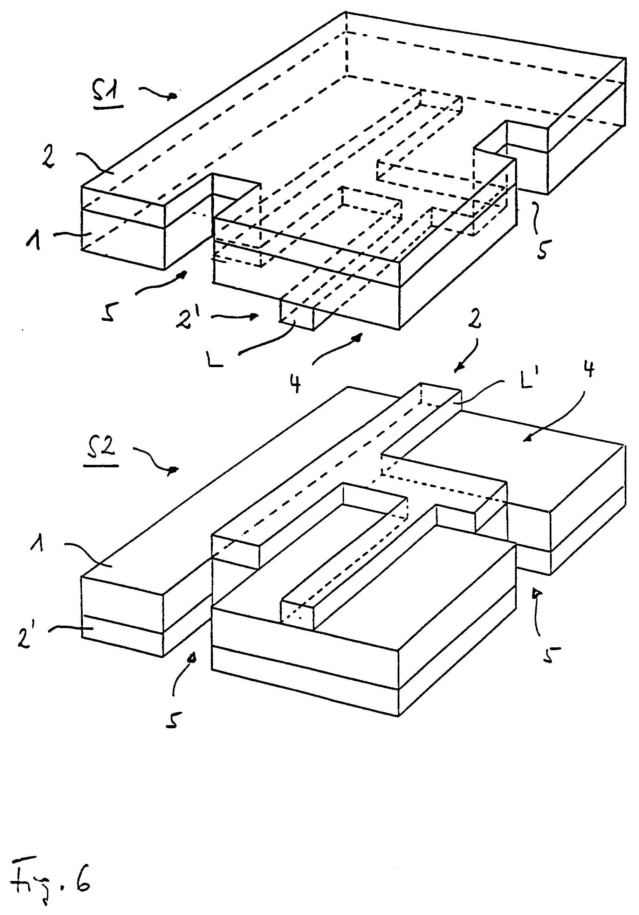

Die beiden Figuren 5 und 6 zeigen in anschaulicher, wenn auch abstrakter Weise die Bildung von Mikrosiebstapeln zu Diaphragmen mit tubularen Kondukten (Figur 5) und Multilayern mit Festkörperkondukten (Figur 6). Zugunsten einer einfachen Darstellung und damit man erkennt, dass dieselbe Technologie in Negativ/Positiv-Darstellung entweder zu einem Diaphragma oder zu einem Multilayer führt, wurde für beide Figuren die gleiche rein willkürliche Anordnung für Kanäle und für Leiterbahnen gewählt. Die Bezugsziffern wurden in Anlehnung an die Figuren 1 bis 3 vergeben.

Figur 5 zeigt zwei aufeinander abgestimmte Mikrosiebe S1 und S2 mit zwei Durchführungen 5 und einem Tubularsystem 4, das mit diesen Durchführungen 5 verbunden ist. Das Tubularsystem entsteht durch die Bildung von Ausnehmungen 4,4'. Die beiden Mikrosiebe S1 und S2, hier nur zwei, in der Regel eine Mehr- bis Vielzahl können auf beiden Seiten 2,2' solche Ausnehmungen aufweisen. Hier wurde auf eine solche Darstellung verzichtet, da damit die Anschaulichkeit verloren gehen würde. Werden nun die beiden Teile gemäss Figur aufeinandergelegt, so resultiert ein System von Kanälen K in x-,y- und z-Richtung. Die Anlage der Kanäle ist, wie gesagt, völlig willkürlich, sie dient lediglich der Illustration. Statt einer spiegelbildlichen Ausführung, die zu Kanälen mit doppelten Querschnitt der Ausnehmungen führt, können strukturell identisch geätzte Mikrosiebe aufeinander gepackt werden, also je eine Schicht 2' mit Ausnehmungen 4 mit einer Schicht 2 ohne solche. Bei dieser Ausführungsform korrespondieren nur die z-Kondukte der Mikrosiebe im Tubulardiaphragma. Mit dem im Zusammenhang mit Figur 4 dargestellten Herstellungsverfahren auf Bandanlagen können mit hoher Herstellungskapazität Mikrosiebe für Vielschichtdiaphragmas hergestellt werden.

Figur 6 zeigt zwei andere aufeinander abgestimmte Mikrosiebe S1 und S2 mit den gleichen Durchführungen 5 und einem Leitersystem 2' bzw. L. Das Leitersystem entsteht ebenfalls durch die Ausnehmungen 4,4'. Die Durchführungen 5 entsprechen einer Durchplattierung, wie sie bei Multilayern üblich ist. Werden die Teile aufeinander gelegt, so resultiert ein System von Leitern L in x-,y- und z-Richtung. Die Anlage der Leiter ist absichtlich an Figur 5 angelehnt, um die Negativ/Positiv-Technik dieser Erfindung zu zeigen. Auch in dieser Ausführungsform kann statt einer spiegelbildlichen Ausführung, die zu Leitern mit doppelten Querschnitt führt, können strukturell identisch geätzte Mikrosiebe aufeinander gepackt werden, also je eine Schicht 2' mit Ausnehmungen 4 mit einer Schicht 2 ohne solche. Bei einer solchen Ausführungsform korrespondieren nur die z-Kondukte der Mikrosiebe, das sind die Durchplattierungen im Leiterdiaphragma oder besser ausgedrückt im Multilayer.

Für Schichtung der Mikrosiebe zu Verbundkörpern, also Diaphragmen oder Multilayern, kann auf verschiedene Weise vorgegangen werden. Die Mikrosiebe werden einzeln hergestellt wobei in bestimmten Abständen zusammen mit dem Herstellungsprozess der Maske Führungszapfen 7 und korrespondierende Einsenkungen oder Vertiefungen hergestellt werden, die beim Zusammenfügen ineinander greifen (Beispiel in Figur 5) und dabei die Lage der Siebe zueinander positionieren (Selbstzentrierung). Das Schichten geschieht entweder automatisch unter Kontrolle von optischen Marken oder von Hand durch Einfassen der Ränder in einen gemeinsamen Rahmen. In dieser Position werden die Siebe miteinander verbunden. Die Verbindung kann durch chemische Anlösung der Oberfläche mit geeigneten Lösungsmitteln oder deren Dämpfe oder bei Thermoplasten durch Wärme geschehen. Das sehr präzise aufeinander Positionieren ist eine bekannte Technik, welche zu diesem Zweck ebenfalls verwendet werden kann.

Verwendet man partiell ausgehärtete Folien, so können vorzugsweise Mikrosiebe mit Hohlkondukten direkt aufeinander positioniert, zentriert und unter Wärmezuführung zusammengepresst und ausgehärtet werden. Bei der Schichtung wird stets eine unbeschichtete Seite ohne Kondukte auf eine beschichtete Seite mit Kondukten gelegt. Sind beide Seiten beschichtet und mit einer Maske versehen, so verwendet man Klebmittel, wovon es für diese Zwecke ein grosses Angebot gibt. Bei Hohlkondukten muss darauf geachtet werden, dass die Kanäle (Tubuli) nicht mit Klebstoff gefüllt werden Bei Diaphragmen ist es vorteilhaft Zwischenlagen mit Durchführungen lediglich in z-Richtung vorzusehen, durch welche die in x,y-Richtung verlaufenden Kanäle verbunden werden. Solche Zwischenlagen werden vorzugsweise mit partiell gehärteten Folien hergestellt, denn eine Verklebung allein mit Wärme setzt die Wahrscheinlichkeit, dass unkontrolliert Kanäle verschlossen werden, stark herab.

Selbstverständlich ist auch eine "Mischtechnik" mit tubularen Kondukten und Festkörper-Kondukten möglich. Ferner darf man nicht ausser Acht lassen, dass sich dies im Gebiet der µ-Technik abspielt, was in Figur 5 mit d-d 20-50 µ-Meter gezeigt wird, welche Technik eine extrem grosse Oeffnungs- und Kondukt-Dichte erlaubt. Auch die mögliche Komplexität von solchen Verbundkörpern ist enorm, wenn man bedenkt, dass bei einem Verbundkörper von nur 1 mm Dicke über 25 Mikrosiebe beteiligt sein können.

## Patentansprüche

1. Verfahren zur Herstellung eines Verbundkörpers mit einem vorgegebenen System von in x-, y- und z-Richtung beliebig vernetzten Leitern und/oder hohlen Kanälen durch Aufeinanderschichten und Verbinden einer Mehrzahl von Mikrosieben, wobei zur Herstellung der Mikrosiebe an Kunststoffolien (1) mit einer ein- oder beidseitigen Beschichtung (2, 2') aus einem Beschichtungsmaterial, das andere Ätzeigenschaften hat als die Kunststoffolien, in mindestens zwei Ätzschritten Durchgänge (5) durch die Kunststoffolie (1) und Beschichtungsstrukturen bestehend aus Beschichtungsteilen (L) und zwischen Beschichtungsteilen angeordneten Ausnehmungen (4, K) erstellt werden, **dadurch gekennzeichnet,** dass die Durchgänge hohl belassen oder in einem weiteren Arbeitsgang mit einem Festkörper gefüllt werden und dass auf hohle Durchgänge Ausnehmungen (K) und auf Durchgänge mit Festkörperfüllung Beschichtungsteile (L) ausgerichtet werden, wobei die Durchgänge und Beschichtungsstrukturen jedes Mikrosiebes zur Bildung des vernetzten Systems von Leitern und/oder Kanälen auf Durchgänge oder Beschichtungsstrukturen von im Verbundkörper benachbarten Mikrosieben abgestimmt werden.

2. Verfahren nach Anspruch 1, **dadurch gekennzeichnet,** dass mit Metall beschichtete Folien verwendet werden, dass die Strukturierung mit photochemischen Mitteln durchgeführt wird, wodurch die verbleibenden Beschichtungsteile (L) aus Metall sind und elektrische Leiter darstellen.

3. Verfahren nach Anspruch 1, **dadurch gekennzeichnet,** dass mit einer optisch durchlässigen Schicht beschichtete Folien verwendet werden, dass die Strukturierung mit photochemischen Mitteln durchgeführt wird, wodurch die verbleibenden Beschichtungsteile (L) aus optischdurchlässigem Material sind und optische Leiter darstellen.

4. Verfahren nach Anspruch 1, **dadurch gekennzeichnet,** dass die Ausnehmungen (K) vor dem Aufeinanderstapeln der Mikrosiebe beschichtet werden.

## Claims

1. Method for producing a multilayer with a predetermined system of conductors and/or hollow channels randomly linked in the x, y and z-direction by stacking and connecting a plurality of microscreens and in which for producing the microscreens on plastic sheets (1) with a coating (2, 2') of a coating material on one or both sides having different etching characteristics to the plastic sheets, in at least two etching steps passages (5) are produced through the plastic sheet (1) and coating structures comprising coating parts (L) and recesses (4, K) between the latter are produced, characterized in that the passages are left hollow or in a further operation filled with a solid and that with such hollow passages are aligned recesses (K) and with passages having a solid filling coating parts (L), the passages and coating structures of each microscreen are matched to passages or coating structures of adjacent microscreens in the multilayer for the formation of the linked system of conductors and/or channels.

2. Method according to claim 1, characterized in that metal-coated sheets are used and that structuring takes place with photochemical media, so that the remaining coating parts (L) are of metal and constitute electrical conductors.

3. Method according to claim 1, characterized in that sheets coated with an optically transparent coating are used and that structuring takes place with photochemical media, so that the remaining coatings parts (L) are of optically transparent material and constitute optical conductors.

4. Method according to claim 1, characterized in that the recesses (K) are coated prior to the stacking of the microscreens.

## Revendications

1. Procédé pour la fabrication d'un corps composite comportant un circuit prédéterminé de conducteurs et/ou canaux creux réticulés arbitrairement en des directions x, y, z, par la superposition en couches et leur assemblage d'une pluralité de microfiltres, la fabrication de ces microfiltres étant réalisée sur des films de matière synthétique (1) enduits sur leurs deux faces ou sur l'une seulement, d'un revêtement (2, 2') fait en une matière dont les propriétés au décapage sont différentes de celles desdits films (1), par la mise en place, en au moins deux opérations de décapage, d'orifices (5) traversant le film (1) et de structurations du revêtement (2, 2') constituées de parcelles (L) de revêtement et entre ces parcelles (L) d'évidements (4, K), caractérisé en ce que les orifices sont ou bien laissés vides, ou bien seront remplis d'un solide au cours d'une opération ultérieure, et que sur les orifices vides sont alignés des évidements (K) et sur les orifices remplis d'un solide sont alignées des parcelles (L) de revêtement, tandis que, pour former le circuit réticulé de conducteurs et/ou de canaux, lesdits orifices et lesdites structurations du revêtement de chaque microfiltre sont ajustés sur les orifices ou les structurations du revêtement des microfiltres voisins à l'intérieur du corps composite.

2. Procédé selon la revendication 1, caractérisé en ce que l'on utilise des films revêtus de métal, en ce que la structuration est réalisée par des moyens photochimiques, ce qui a pour effet que les parcelles (L) restantes de revêtement sont en métal et forment des conducteurs électriques.

3. Procédé selon la revendication 1, caractérisé en ce que l'on utilise des films revêtus d'une couche optiquement transparente, que la structuration est effectuée par des moyens photochimiques, ce qui a pour effet que les parcelles (L) restantes de revêtement sont en une matière optiquement transparente et constituent des conducteurs optiques.

4. Procédé selon la revendication 1, caractérisé en ce que l'enduction des évidements (K) s'effectue avant l'empilage des microfiltres.
